# EUROPEAN PATENT SPECIFICATION

(11) **EP 0 421 605 B1**
(45) Date of publication and mention of the grant of the patent: **27.05.1998**
(21) Application number: 90309592.5
(22) Date of filing: 31.08.1990
(51) Int. Cl.: H01L 21/20

(54) **Process for forming semiconductor thin film**
Verfahren zur Herstellung einer Halbleiterdünnschicht
Procédé de formation d'un film fin semi-conducteur

(30) Priority: 07.09.1989 JP 233940/89
(43) Date of publication of application: 10.04.1991
(73) Proprietor: CANON KABUSHIKI KAISHA, Tokyo (JP)
(72) Inventor: Ichikawa, Takeshi, c/o Canon K.K., Tokyo (JP); Yonehara, Takao, c/o Canon K.K., Tokyo (JP)
(74) Representative: Beresford, Keith Denis Lewis

(56) References cited:
- EP-A- 0 306 153
- US-A- 4 757 030
- US-A- 4 824 546
- APPL. PHYS. LETT., vol. 53, no. 1, 4th July 1988, pages 45-47, New York, US; T. OHMI et al.: "In situ substrate-surface cleaning for very low temperature silicon epitaxy by low-kinetic-energy particle bombardment"
- APPL. PHYS. LETT., vol. 53, no. 5, 1st August 1988, pages 364-366, New York, US; T. OHMI et al.: "Low-temperature silicon epitaxy by low-energy bias sputtering"
- Applied Physics Letters, vol. 48, no. 12, 24th March 1986, pp. 773-775
- Japanese Journal of Applied Physics, vol. 26, no. 11, November 1987, pp. 1816-1822
- Journal of Applied Physics, vol. 49, no. 11, November 1978, pp. 5595-5601

## Description

### BACKGROUND OF THE INVENTION

### Field of the invention

This invention relates to a method for forming a semiconductor thin film, particularly to a method for forming a single crystal region of semiconductor thin film on an amorphous insulating surface. The present invention can be used, for example, as an SOI technique.

### Related Background Art

In the prior art, a single crystal thin film indispensable for formation of a semiconductor device has been formed generally by epitaxial growth from a single crystal substrate.

However, according to this method, no single crystal can be grown on an amorphous substrate, and it is extremely difficult to effect crystal growth of a crystalline material having different lattice constants or coefficient of thermal expansion from those of the single crystal substrate, whereby the substrate material and the kind of the grown film have been limited.

On the other hand, in research and development in recent years, there have been active developments of three-dimensional integrated circuits to effect higher integration and multiple functionalization by lamination of semiconductor devices on a substrate, or switching transistors of liquid crystal picture elements in which solar batteries or devices are arranged in arrays by depositing semiconductor materials on an inexpensive glass substrate. The technique of realizing a structure having a semiconductor thin film of high quality formed on an amorphous insulating substrate (SOI structure) common to these devices is becoming important.

In recent years, for realizing such SOI structure, various researches have been done, and the lateral solid phase growth method (L-SPE) which can be practiced at a process temperature of 600 ^{o}C or lower is one of the techniques particularly expected.

However, for causing solid phase growth to occur with the single crystal of the substrate as the seed crystal, because electrical insulation from the substrate has not been accomplished, and also because polycrystalline region is formed due to random nucleus generation and growth occurring primarily at the SiO₂-amorphous silicon interface within amorphous silicon remote from the seed crystal on the substrate, the growth distance from the seed crystal is very short as several µm to 10 and several µm, and further there are still many tasks for device application such as the problem of defects remaining within the L-SPE layer (many twin crystals, and dislocations). In order to solve these problems and introducing the L-SPE technique into device application, the surface cleaning technique of the substrate before deposition of amorphous semiconductor layer becomes very important. Recently, there have been practiced (1) heat treatment at 800 °C under ultra-high vacuum (H. Ishiwara, A. Tamba, and S. Furukawa, Appl. Phys. Lett. 48, 773 (1986)), (2) cleaning by Ar sputtering (heat treatment at 680 °C) (K. Kusukawa, M. Moniwa, E. Murakami, M. Miyao, T. Warabisako, and Y. Wada, Extended Abstracts of the 19th Conference on Solid State Devices and Materials, Tokyo, 1987, pp 179 - 182), (3) etching with Si₂H₆/H₂ gas (heat treatment at 850 °C) (Y. Kunii, and Y. Sakakibara, Jpn. J. Appl. Phys. 26, 1816 (1987)), but in view of the lowered temperature process, cleaning by sputtering of (2) may be considered desirable. The sputter cleaning of the semiconductor with argon has been also used as the pre-treatment of low temperature silicon epitaxial growth by CVD, and although argon ions having an energy higher than the sputtering threshold value of the substrate material, i.e. generally more than 100 eV are used, since heat is generated,
radiation damage and other damage caused at the time of sputtering are reduced (W. R. Burger, J. H. Comfort, L. M. Garverick, T. R. Yew, and R. Rief, IEEE ELECTRON DEVICE LETTERS, Vol. EDL-8 pp. 168 (1987)).

At present, even when the cleaning techniques of (1) - (3) may be employed, the growth distance in the lateral growth is short, and there are many crystal defects in the semiconductor thin film formed and there are many remaining tasks for device preparation.

### SUMMARY OF THE INVENTION

The above problems have been addressed as described hereinbelow in particular the present invention is intended as a method of forming a region of high quality single crystal semiconductor thin film of area large enough for device definition and with characteristics similar to those of quality bulk single crystal material.

The method in accordance with the present invention is specified in claim 1 of the claims appended. A particular feature of this method is that surface adherents are removed from the surface of a single-crystal seed region and the surrounding surface of the substrate prior to sputter deposition of an amorphous film of semiconductor material using a two-frequency technique as specified so that ions are caused to irradiate the surface of the single-crystal seed region and the surrounding surface of the substrate at an energy lower than the sputtering threshold value of each surface.

The measurements reported below show that the characteristics of a MOSFET grown on such film are equivalent to those produced on a bulk substrate. Since these have semiconductor on insulator (SOI) structure, high speed operation, high performance with little parasitic capacity with the substrate and increased radiation resistance are achieved it is possible to fabricate three dimensional integrated circuits, high performance solar batteries on glass, etc.

### BRIEF DESCRIPTION OF THE DRAWINGS

Figs. 1A to 1D are schematic sectional views showing successive stages of a method of forming semiconductor thin film which embodies the present invention;
Fig. 2 is a schematic view showing an example of a bias sputtering apparatus using two-frequency excitation;
Figs. 3A to 3C are diagrams for illustration of an example of a method of forming fine single crystal seeds;
Fig. 4 is a diagram for illustration of an example in which fine single crystal seeds are exposed at the surface of a substrate;
Fig. 5 is a schematic sectional view of an MOS type transistor produced by a process embodying the present invention.

### DETAILED DESCRIPTION OF THE PREFERRED EMBODIMENTS

Referring now to the drawings, embodiments of the present invention are described below in detail. The following description is given by way of example only.

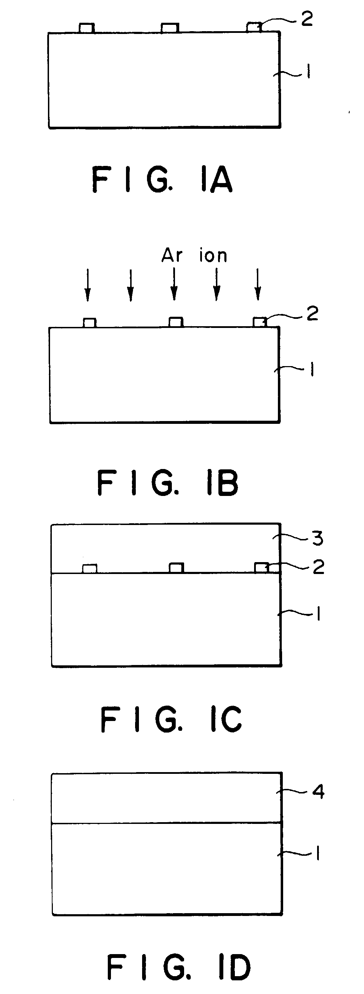

Fig. 1 is a schematic sectional view showing the preparation steps of a method for forming semiconductor thin film.

First, as shown in Fig. 1A, by use of a conventional method for formation of seed crystals, fine single crystal regions 2 are formed on the surface of an amorphous insulating substrate 1. According to the method as described below, by use of ions controlled precisely to an energy of several eV, surface adherents on the single crystal region and on the amorphous insulating substrate are removed leaving a clean exposed surface (Fig. 1B). An amorphous semiconductor layer 3 is then deposited within the same apparatus before contaminants are adsorbed on the clean exposed surface (Fig. 1C).

Here, cleaning for removal of the above-mentioned surface adherents is performed by use of ions controlled in energy magnitude. Specifically, the energy of these ions is an energy lower than the sputtering threshold value of the above-mentioned single crystal region and the above-mentioned amorphous insulating substrate, and may be made preferably 40 eV or less, more preferably 10 eV or less.

It is desirable that the surface cleaning step and the later deposition step of the amorphous semiconductor layer should be performed continuously so that no contaminant may be adsorbed.

An example of removing surface adherents with ions controlled precisely in energy to several eV has been realised within the rf-dc junction bias sputtering apparatus in the form of cleaning of silicon surface with argon ions (T. Ohmi, T. Ichikawa, T. Shibata, K. Matsudo and H. Iwabuchi, Appl. Phys. Lett. 53, 45 (1988)), and by performing sputtering film formation in the same apparatus immediately after the cleaning step, thin films exhibiting various crystallinities from single crystal silicon to amorphous silicon which depend on the irradiation energy to the substrate can be deposited on a silicon substrate (T. Ohmi, K. Matsudo, T. Shibata, T. Ichikawa, and H. Iwabuchi, Appl. Phys. Lett. 53, 364 (1988)).

However, in the above-mentioned rf-dc junction bias sputtering apparatus, when the material to be treated is an electrical insulator, the potential of the substrate which is the material to be treated could not be controlled.

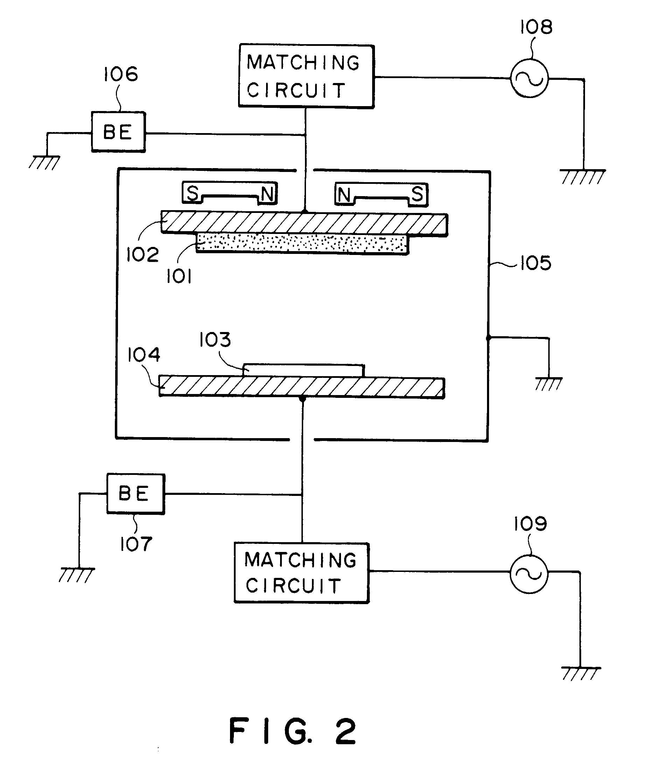

Instead, substrate surface cleaning is realised by an rf bias sputtering apparatus using two frequency excitation (see Fig. 2). Such apparatus, for example, is described in US-A-4 824 546. Treatment, using this apparatus, is described in detail below.

After deposition of an amorphous semiconductor layer, solid phase growth is performed with each single crystal region as a seed crystal by application of heat treatment, whereby a single crystal thin film 4 of high quality can be grown on the amorphous insulating substrate (Fig. 1D). Because contaminants at the interface. between the single crystal region and the amorphous semiconductor layer or on the amorphous insulating substrate have been removed, random nucleus generation caused to occur within amorphous silicon and formation of unwanted polycrystalline regions by growth of said random nucleus, can be inhibited, to increase the growth distance of the single crystal grown from the seed crystal, whereby the crystallinity of the single crystal thin film formed is also of good quality.

The surface cleaning of the substrate by means of a bias sputtering apparatus using two frequency excitation and the deposition of amorphous silicon are described below.

In the space between the target holder 102 and the susceptor 104 shown in Fig. 2, a plasma of, for example, hydrogen, argon, xenon, neon or a gas mixture of these is formed by high frequency energy, and by controlling the energy power, or frequency of the high frequency applied to the substrate 103, or the impedance between the substrate 103 and the earth, ions are irradiated on the substrate with an energy smaller than the sputter threshold of the substrate 103, whereby the surface adherents (primarily of water molecules) can be removed without damaging the substrate 103. More specifically, by maintaining the high frequency supplied to the susceptor 104 mounted on the substrate 103 at a higher frequency and smaller power than the frequency applied to the target holder 102 for mounting the target 101, and also by controlling the impedance between the susceptor 104 and the earth by use of the impedance control means 107 so that higher frequency energy controlled in power can be supplied to the susceptor 104, the self-bias of the substrate 103 having the insulating material surface is kept smaller. On the clean surface thus obtained, semiconductor material for solid phase growth such as amorphous silicon, etc. is deposited by sputtering of the target 101 (sputtering phenomenon of target material is caused to occur by irradiating ions of argon, etc. having an energy of the difference between the plasma potential and the target potential to the target 101 through self-bias by plasma or bias control by the direct current power source 106). Since this process can be performed continuously within the same apparatus, contaminants can be removed from between the substrate or the single crystal region and the amorphous silicon deposited, and the solid phase growth thereafter can be done smoothly. Also, disturbance of impurity contamination during device preparation can be also removed.

In the cleaning step for making the surface of the substrate 103 as described above a clean surface, it is desirable that the frequency of the high frequency energy supplied from the power source 109 should be a frequency higher than the frequency of the high frequency energy supplied from the power source 108, and the high frequency energy supplied from the power source 109 should have a lower energy than the high frequency energy supplied from the power source 108 from the standpoints of control of the self-bias of the substrate 103 and control of energy of ions.

Here, the impedance control means 107 for controlling the self-bias of the substrate 103 may be preferably a band pass filter having a capacitor (C) and a coil (L), etc. The above impedance control means 107 can become desirably minimum in impedance at the frequency of the high frequency energy supplied from above-mentioned power source 108 for control of the self-bias of the substrate 103.

The above-mentioned direct current power source 106 may be also provided with a power source protection means such as low pass filter, etc.

The frequency of the high frequency energy to be supplied to the above-mentioned susceptor 104 should be 100 MHz or higher and 3 GHz or lower, preferably 150 MHz or more and 1 GHz or lower.

On the other hand, the frequency of the high frequency energy to be supplied to the above-mentioned target holder should be made 1 MHz or higher and 1 GHz or lower, preferably 10 MHz or higher and 300 MHz or lower.

Here, the ratio of the frequencies of the high frequency energies to be supplied to the above-mentioned target holder and the above-mentioned susceptor should be 0.75 or lower.

The power of the high frequency energy to be supplied to the above-mentioned susceptor should be made 0.01 W/cm² or higher and 1 W/cm² or lower, preferably 0.05 W/cm² or higher and 0.5 W/cm² or lower.

As the method for forming single crystal regions (seed crystals) at desired position of a substrate having an amorphous insulating surface which can be used in the present invention, there may be included, for example, (1) a method in which a single crystalline substrate material surface is covered with an amorphous insulating material having openings at each desired position, (2) a method in which an energy beam such as laser beam, etc. is directed at each desired position to effect melt recrystallisation of each primary seed, (3) a method in which small primary seeds each sufficient for formation of a single agglomerate by heat treatment are arranged at each desired position of an amorphous insulating substrate, agglomerated and each formed into a single crystal seed by heat treatment, (4) a method in which a primary seed is arranged at each desired position of an amorphous insulating substrate, and secondary nucleus growth (abnormal grain growth) is effected by heat treatment.

The amorphous insulating substrate in the present invention may be one having an amorphous insulating material at least on the substrate surface. For example, a silicon wafer or a quartz glass with an oxidised surface, a substrate having elements formed thereon and which is covered with a layer of an amorphous insulating material such as SiO₂, SiN, etc.

Also, in the embodiments as described above, silicon is mentioned as an example of the crystalline material for solid phase growth, but the crystalline material which can be formed by the formation process of the semiconductor film of the present invention is not limited only to silicon. As other crystalline materials to which the present invention is applicable, there may be included, for example, the following semiconductor materials Ge, Si-Ge, Si-C, Si-Ge-C, Si-Sn, Se, Se-Te, GaAs.

### Example 1

In the following, Examples of the present invention are described in detail.

First, after an amorphous silicon film or a polysilicon film was deposited by LP-CVD to a film thickness of 100 nm (1000 Å) on an amorphous SiO₂ insulating substrate, P was doped at a dose of 3.8 x 10¹⁵ cm⁻² at an acceleration voltage of 10 KeV to make the silicon thin film amorphous. After resist patterning, the amorphous silicon was patterned by plasma etching to sizes of 1.2 µm square and the respective distances of 50 µm, and the amorphous silicon was formed into single crystal by abnormal grain growth by performing heat treatment in an N₂ atmosphere at 1000°C for 30 minutes to form seed crystals. And, by use of the rf bias sputtering apparatus shown in Fig. 2, a high frequency energy of 190 MHz, 10 W was supplied to the substrate, and a high frequency energy of 100 MHz, 20 W to the target, and also a DC bias of -25 V was applied to the target.

At this time, the inner pressure within the above-mentioned rf bias sputtering apparatus was maintained at 1.3 Pa (10 mTorr) and the substrate temperature at 100°C for 5 minutes, and the above substrate was subjected to cleaning with argon ions having an energy of 5 eV.

The surface adherents, on the single crystal seed crystal and on the amorphous substrate, were removed by Ar ions to leave a clean exposed surface. An amorphous silicon film was deposited to a film thickness of 200 nm (2000 Å) by sputtering of the target material within the same apparatus before any contaminants were adsorbed on the clean exposed surface.

The formation conditions of the amorphous silicon film were made a high frequency energy of 190 MHz, 25 W supplied to the substrate, a high frequency energy of 100 MHz, 200 W supplied to the target, and a DC bias of -250 V applied to the target, an argon gas pressure of 1.3 Pa (10 mTorr), and a substrate temperature of 100 °C.

Next, by performing heat treatment of 600 °C, 50 hours in an N₂ atmosphere, solid phase growth with the single crystal region as the seed crystal was permitted to occur, thereby growing the single crystal thin film region of high quality over the whole surface on the amorphous insulating substrate (25 µm or more of the growth distance of L-SPE). In the above-described Example, the formation method of the portion which becomes the seed crystal of single crystal is not limited to the method shown above, but a fine single crystal region may be consequently formed.

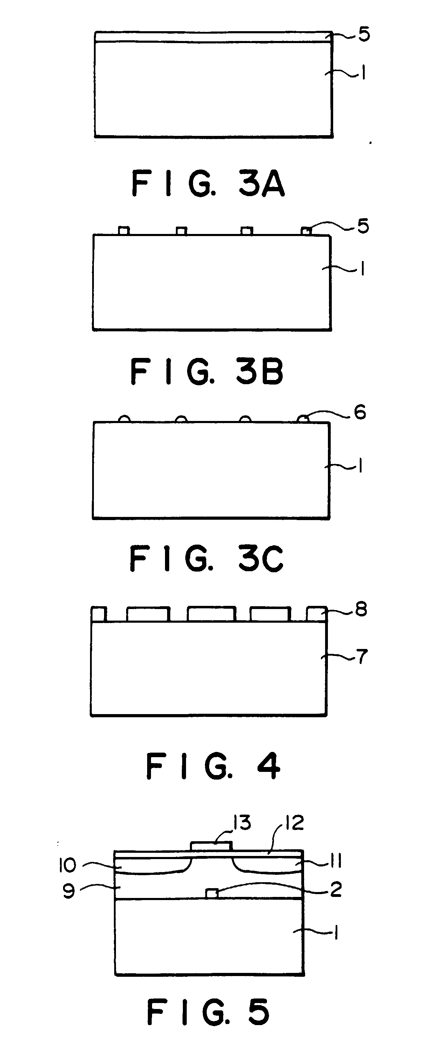

For example, as shown in Fig. 3, on the surface of the amorphous insulating substrate 1 constituting the deposition surface, after forming thinly an amorphous silicon film or a polysilicon film, P may be doped at a dose of 3.8 x 10¹⁵ cm⁻² and an acceleration voltage of 10 KeV to make the silicon thin film amorphous (Fig. 3A), and after resist patterning, the amorphous silicon film 5 patterned to sizes of 0.9 µm square (Fig. 3B), followed by heat treatment in H₂ atmosphere at 950°C for 3 minutes to make amorphous silicon single-crystallised. There is no problem at all using such method. At this time, agglomeration occurs, and the single crystalline seed 6 has no facet, but becomes an hemispherical agglomerate (Fig. 3C).

Also, as shown in Fig. 4, after formation of an insulating film 8 such as oxidised film on a silicon wafer 7, patterning may be effected and parts of the silicon surface exposed to make single crystalline seed crystals, but in this case, the silicon thin film formed has the drawback that it is not completely separated by insulation from the substrate.

### Example 2

Fig. 5 is a schematic sectional view of an MOS type transistor that can be produced using the above-described process. In the same Figure, 9 is a P-type semiconductor region. 10 and 11 are N-type semiconductor regions, forming respectively the source and the drain of the transistor. 12 is a gate oxidised film formed on the P-type semiconductor region 9 and the N-type semiconductor regions 10 and 11, and 13 the gate electrode such as of polysilicon formed on the gate oxidised film 12. Because this MOS type transistor is formed on an insulating substrate, it has the advantages that there are no latch-up or α-ray disorder. Also, the channel mobility of the n-MOSFET thus obtained was found to be 550 cm²/V s a maximum (representative value 350 cm²/V s). The gate width = 4 µm, effective and the leak current during OFF equal or close to the value of a bulk FET.

It has thus become possible to grow a single crystal thin film of high quality on an amorphous insulating substrate which is large enough for preparation of a device. The characteristics of a MOSFET formed within the single crystal thin film can be equal to those of a MOSFET formed in a bulk substrate.

Further, due to the SOI structure, application to devices such as high speed, high performance devices with little parasitic capacity with the substrate, typically three-dimensional integrated circuits, high performance solar batteries on glass substrates, radiation resistant devices, etc. has been rendered possible.

## Claims

1. A method of forming a monocrystalline region of thin film (4,9) of a semiconductor material on an amorphous insulating surface, which method comprises:
providing a substrate (1) having an amorphous insulating surface and a single-crystal seed region of said semiconductor material (2; 6; 7);
producing an amorphous film (3) of said semiconductor material covering said single-crystal seed region (2; 6; 7) and said amorphous insulating surface; and
heating said amorphous film (3) to cause single-crystalline material to grow in the solid phase from said single-crystal seed region (2; 6; 7) as originating point laterally across said amorphous insulating surface to form said monocrystalline region of thin film of said semiconductor material (4; 9);
which method is characterised by the steps of:
i) surface adherents are removed from the exposed surface of said single-crystal seed region (2; 6; 7) and from the exposed amorphous insulating surface by an rf bias sputtering process in which said substrate (1) is mounted on a susceptor (104) opposite a target holder (102), a signal of a first frequency is applied to said target holder (102), and a signal of a second frequency and a low power in the range of 0.01 to W/cm² to 1 W/cm² is applied to said susceptor (104) so that ions are caused to irradiate the exposed surface of said single-crystal seed region (2; 6; 7) and the exposed amorphous insulating surface at an energy lower than the sputtering threshold value of each; and thereafter
ii) said amorphous film (3) is produced by applying a signal of said first frequency to said target holder (102) and a signal of said second frequency to said susceptor (104) and thereby by sputtering a target (101) mounted on said target holder (102) to deposit said semiconductor material on the exposed surface of said single-crystal seed region (2; 6; 7) and the exposed amorphous insulating surface from which said surface adherents have been removed; and
wherein said first frequency is selected from the range of 1 MHz to 1 GHz, said second frequency is selected from the range of 100 MHz to 3 GHz, the ratio of said first and second frequencies is 0.75 or less, and said lower power is smaller that the power applied to the target holder, and steps i) and ii) are performed continuously within the same apparatus.

2. A method as claimed in claim 1, wherein said susceptor (104) is earthed through an impedance control means (107).

3. A method as claimed in claim 1, wherein a DC bias is applied to said target holder (104).

4. A method as claimed in claim 1, wherein the ions for removing said surface adherents are formed by a plasma of hydrogen, argon, xenon, neon or a gas mixture of these.

5. A method as claimed in claim 1, wherein said single-crystal seed region (2) is disposed on said amorphous insulating surface (1).

6. A method as claimed in claim 1, wherein said single-crystal seed region (7) is a monocrystalline substrate (7) exposed at an opening in an amorphous insulating layer (8) on said monocrystalline substrate, and said amorphous insulating layer provides said amorphous insulating surface.

7. A method as claimed in claim 1, wherein said single-crystal seed region is provided in plural number.

8. A method of producing a MOSFET comprising the following steps:
forming a monocrystalline region of thin film (9) of a silicon semiconductor material on an amorphous insulating surface of a substrate (1) by the method of claim 1;
forming source and drain regions (10,11) in the surface of said monocrystalline region of thin film (9); oxidising the surface of said thin film (9) to form a gate oxide film (12); and
forming a gate electrode (13) on said gate oxide film (12).

## Patentansprüche

1. Verfahren zum Ausbilden eines monokristallinen Dünnfilmbereichs (4,9) eines Halbleitermaterials auf einer amorphen isolierenden Oberfläche, wobei das Verfahren umfaßt:
Bereitstellen eines Substrats (1), das eine amorphe isolierende Oberfläche und einen Einkristallkeimbereich des Halbleitermaterials (2; 6; 7) aufweist;
Erzeugen eines amorphen Films (3) des Halbleitermaterials, der den Einkristallkeimbereich (2; 6; 7) und die amorphe isolierende Oberfläche bedeckt; und
Erhitzen des amorphen Films (3), um herbeizuführen, daß einkristallines Material in der festen Phase von dem Einkristallkeimbereich (2; 6; 7) als Entstehungspunkt aus lateral über die amorphe isolierende Oberfläche wächst, um den monokristallinen Dünnfilmbereich des Halbleitermaterials (4; 9) auszubilden;
**gekennzeichnet durch** die Schritte:
i) Entfernen von an der Oberfläche anhaftenden Substanzen von der freiliegenden Oberfläche des Einkristallkeimbereichs (2; 6; 7) und von der freiliegenden amorphen isolierenden Oberfläche durch einen HF-Vorspannungs-Sputtervorgang, bei dem das Substrat (1) gegenüber einem Targethalter (102) an einem Suszeptor (104) angebracht wird, ein Signal mit einer ersten Frequenz an den Targethalter (102) angelegt wird und ein Signal mit einer zweiten Frequenz und einer niedrigeren Leistung im Bereich von 0,01 K/cm² bis 1 W/cm² an den Suszeptor (104) angelegt wird, so daß herbeigeführt wird, daß Ionen die freiliegende Oberfläche des Einkristallkeimbereichs (2; 6; 7) und die freiliegende amorphe isolierende Oberfläche mit einer niedrigeren Energie als dem jeweiligen Sputterschwellenwert bestrahlen; und danach
ii) Erzeugen des amorphen Films (3) durch Anlegen eines Signals mit der ersten Frequenz an den Targethalter (102) und eines Signals mit der zweiten Frequenz an den Suszeptor (104), wobei auf diese Weise durch Sputtern eines an dem Targethalter (102) angebrachten Targets (101) das Halbleitermaterial auf die freiliegende Oberfläche des Einkristallkeimbereichs (2; 6; 7) und die freiliegende amorphe isolierende Oberfläche, von denen die an der Oberfläche anhaftenden Substanzen entfernt worden sind, abgeschieden wird; und
wobei die erste Frequenz aus dem Bereich von 1 MHz bis 1 GHz gewählt wird, die zweite Frequenz aus dem Bereich von 100 MHz bis 3 GHz gewählt wird, das Verhältnis der ersten und der zweiten Frequenz 0,75 oder weniger beträgt und die niedrigere Leistung geringer als die an den Targethalter angelegte Leistung ist, wobei die Schritte i) und ii) kontinuierlich innerhalb desselben Geräts ausgeführt werden.

2. Verfahren nach Anspruch 1,
**dadurch gekennzeichnet, daß**
der Suszeptor (104) über eine Impedanzsteuerungseinrichtung (107) geerdet ist.

3. Verfahren nach Anspruch 1,
**dadurch gekennzeichnet, daß**
eine Gleichspannungsvorspannung an den Targethalter (102) angelegt ist.

4. Verfahren nach Anspruch 1,
**dadurch gekennzeichnet, daß**
die Ionen zum Entfernen der an der Oberfläche anhaftenden Substanzen durch ein Plasma aus Wasserstoff, Argon, Xenon, Neon oder einer Gasmischung aus diesen gebildet werden.

5. Verfahren nach Anspruch 1,
**dadurch gekennzeichnet, daß**
der Einkristallkeimbereich (2) auf der amorphen isolierenden Oberfläche (1) angeordnet ist.

6. Verfahren nach Anspruch 1,
**dadurch gekennzeichnet, daß**
der Einkristallkeimbereich (7) ein monokristallines Substrat (7) ist, das an einer Öffnung in einer amorphen isolierenden Schicht (8) auf dem monokristallinen Substrat freiliegt, wobei die amorphe isolierende Schicht die amorphe isolierende Oberfläche bereitstellt.

7. Verfahren nach Anspruch 1,
**dadurch gekennzeichnet, daß**
eine Vielzahl von Einkristallkeimbereichen bereitgestellt ist.

8. Verfahren zur Herstellung eines MOSFET, das die folgenden Schritte umfaßt:
Ausbilden eines monokristallinen Bereichs aus Dünnfilm (9) eines Siliziumhalbleitermaterials auf einer amorphen isolierenden Oberfläche eines Substrats (1) mittels des Verfahrens nach Anspruch 1;
Ausbilden von Source- und Drainbereichen (10,11) in der Oberfläche des monokristallinen Dünnfilmbereichs (9);
Oxidieren der Oberfläche des Dünnfilms (9), um einen Gate-Oxidfilm (12) auszubilden; und
Ausbilden einer Gate-Elektrode (13) auf dem Gate-Oxidfilm (12).

## Revendications

1. Procédé pour former une région monocristalline de film mince (4, 9) d'une matière semiconductrice sur une surface isolante amorphe, procédé qui comprend les étapes consistant :
à prendre un substrat (1) comportant une surface isolante amorphe et une région de germe monocristallin de ladite matière semiconductrice (2 ; 6 ; 7) ;
à produire un film amorphe (3) de ladite matière semiconductrice couvrant ladite région de germe monocristallin (2 ; 6 ; 7) et ladite surface isolante amorphe ; et
à chauffer ledit film amorphe (3) pour provoquer la croissance de la matière monocristalline dans la phase solide à partir de ladite région de germe monocristallin (2 ; 6 ; 7) comme point d'origine latéralement à travers ladite surface isolante amorphe pour former ladite région monocristalline de film mince de ladite matière semiconductrice (4 ; 9) ;
procédé qui est caractérisé par les étapes consistant :
i) à éliminer les matières adhérentes de surface de la surface exposée de ladite région de germe monocristallin (2 ; 6 ; 7) et de la surface isolante amorphe exposée par un procédé de pulvérisation cathodique à polarisation rf dans lequel le substrat (1) est monté sur un suscepteur (104) opposé à un support de cible (102), à appliquer un signal à une première fréquence audit support de cible (102), et à appliquer un signal à une seconde fréquence et une faible puissance comprise dans l'intervalle de 0,01 W/cm² à 1 W/cm² audit suscepteur (104) de telle sorte que des ions soient amenés à irradier la surface exposée de ladite région de germe monocristallin (2 ; 6 ; 7) et la surface isolante amorphe exposée à une énergie inférieure à la valeur seuil de pulvérisation cathodique de chacune ; et ensuite
ii) à produire ledit film amorphe (3) par application d'un signal à ladite première fréquence audit support de cible (102) et un signal à ladite seconde fréquence audit suscepteur (104) et ainsi, en soumettant à une pulvérisation cathodique une cible (101) montée sur ledit support de cible (102), à déposer ladite matière semiconductrice sur la surface exposée de ladite région de germe monocristallin (2 ; 6 ; 7) et la surface isolante amorphe exposée de laquelle lesdites matières adhérentes de surface ont été éliminées ; et
ladite première fréquence étant choisie dans l'intervalle de 1 MHz à 1 GHz, ladite seconde fréquence étant choisie dans l'intervalle de 100 MHz à 3 GHz, le rapport de ladite première fréquence à ladite seconde fréquence étant égal ou inférieur à 0,75, et ladite plus faible puissance étant inférieure à la puissance appliquée au support de cible, et les étapes i) et ii) étant mises en oeuvre de manière continue dans le même appareil.

2. Procédé suivant la revendication 1, dans lequel le suscepteur (104) est mis à la terre par un moyen de contrôle d'impédance (107).

3. Procédé suivant la revendication 1, dans lequel une polarisation de courant continu (CC) est appliquée au support de cible (104).

4. Procédé suivant la revendication 1, dans lequel les ions pour l'élimination des matières adhérentes de surface sont formés par un plasma d'hydrogène, d'argon, de xénon, de néon ou d'un mélange gazeux de ces éléments.

5. Procédé suivant la revendication 1, dans lequel la région de germe monocristallin (2) est disposée sur la surface isolante amorphe (1).

6. Procédé suivant la revendication 1, dans lequel la région de germe monocristallin (7) consiste en un substrat monocristallin (7) exposé au niveau d'un orifice dans une couche isolante amorphe (8) sur ledit substrat monocristallin, et ladite couche isolante amorphe fournit ladite surface isolante amorphe.

7. Procédé suivant la revendication 1, dans lequel la région de germe monocristallin est présente en plusieurs exemplaires.

8. Procédé pour la production d'un transistor semiconducteur à oxyde métallique à effet de champ (MOSFET), comprenant les étapes consistant :
à former une région monocristalline de film mince (9) d'une matière semiconductrice en silicium sur une surface isolante amorphe d'un substrat (1) par le procédé suivant la revendication 1 ;
à former des régions de source et de drain (10, 11) dans la surface de ladite région monocristalline de film mince (9) ; à oxyder la surface dudit film mince (9) pour former un film d'oxyde de grille (12) ; et
à former une électrode de grille (13) sur ledit film d'oxyde de grille (12).
